# EUROPÄISCHE PATENTSCHRIFT

(11) **EP 2 456 034 B1**
(45) Veröffentlichungstag und Bekanntmachung des Hinweises auf die Patenterteilung: **07.02.2018**
(21) Anmeldenummer: 11189392.1
(22) Anmeldetag: 16.11.2011
(51) Int. Cl.: H02H 3/02, H02J 1/10, H02J 3/38

(54) **Photovoltaikanlage und Photovoltaikmodul**
Photovoltaic assembly and photovoltaic module
Installation photovoltaïque et module photovoltaïque

(30) Priorität: 19.11.2010 DE 102010052009
(43) Veröffentlichungstag der Anmeldung: 23.05.2012
(73) Patentinhaber: Kostal Industrie Elektrik GmbH, 58513 Lüdenscheid (DE)
(72) Erfinder: Forck, Andreas, 45739 Oer-Erkenschwick (DE); Schmidt, Kay-Hendryk, 58452 Witten (DE)
(74) Vertreter: Kerkmann, Detlef

(56) Entgegenhaltungen:
- EP-A1- 2 249 393
- EP-A2- 1 172 777
- EP-A2- 2 101 391
- WO-A2-2008/077473
- US-A1- 2010 139 734

## Beschreibung

Die Erfindung betrifft eine Photovoltaikanlage mit Photovoltaikmodulen, die jeweils mindestens einen aus mehreren Solarzellen bestehenden Panelstring aufweisen, wobei mehrere Photovoltaikmodule miteinander in Reihe zu Modulsträngen verschaltet sind, und mit einer Elektronik zum Freischalten von Photovoltaikmodulen, deren Versorgungsspannung durch wenigstens eines der Photovoltaikmodule generiert wird.

Eine derartige Photovoltaikanlage ist aus der US 2010/0139734 A1 bekannt.

Die Erfindung betrifft außerdem ein Photovoltaikmodul, das vorteilhaft innerhalb einer derartigen Photovoltaikanlage verwendbar ist.

Eine Photovoltaikanlage enthält üblicherweise mehrere Photovoltaikmodule aus miteinander zu so genannten Panelstrings verbundenen Solarzellen, die miteinander in Reihe zu Modulsträngen, auch als Strings bezeichnet, verschaltet sind. Die Modulstränge liefern eine Gleichspannung, die, zumeist nach einer Anpassung der Spannungshöhe durch einen Gleichspannungswandler, mittels eines Wechselrichters in eine Wechselspannung umgesetzt wird. Die vom Wechselrichter abgegebene Wechselspannung kann in das Netz eines Energieversorgers eingespeist werden. Photovoltaikanlagen, die mehrere Modulstränge aufweisen sind beispielsweise aus der DE 199 19 766 A1 und der DE 101 36 147 B4 bekannt. Ein Problem jedes Photovoltaikgenerators ist, dass dieser beinahe eine ideale Stromquelle ist, solange er von der Sonne beschienen wird. Das bedeutet auch, dass im Brand- bzw. Gefahrenfall weiter Energie erzeugt wird. Um diesem Problem zu begegnen, ist es bekannt, eine Elektronik zum Freischalten von Photovoltaikmodulen vorzusehen. Bei der Anwendung von reversiblen elektronischen Schaltelementen wird eine elektronische Logik verwendet, welche auf externe oder interne Ereignisse oder physikalische Messgrößen reagiert und die Schaltelemente steuert. Diese Elektronik benötigt eine Versorgungsspannung. Für die Energieversorgung der Elektronik sind die nachfolgend genannten Möglichkeiten bekannt, welche jeweils spezifische Nachteile aufweisen.

So besteht die Möglichkeit, einem Photovoltaikmodul Energie über zusätzliche Leitungen zuzuführen, die mit einer externen Energiequelle verbunden sind. Dies erfordert neben der externen Energiequelle einen zusätzlichen Verkabelungsaufwand und schafft damit verhältnismäßig hohe Kosten.

Eine andere Möglichkeit besteht darin, die bei Sonneneinstrahlung von den Modulsträngen generierte elektrische Energie zum Auftrennen des stromführenden Modulstrangs im Gefahrenfall zu nutzen. Ein Trennen der Modulstrangleitungen allein beinhaltet allerdings die Gefahr des Auftretens von Lichtbögen. Des Weiteren wäre aufgrund des Trennens der Modulstrangleitungen ein zusätzlicher Kommunikationsring, etwa über Funkverbindungen oder zusätzliche Leitungen, erforderlich um eine Wiedereinschaltinformation an die Anschlussdose heranzutragen.

Alternativ kann auch eine Nutzung des Spannungsabfalls an parallel zum Modulstrang geschalteten Bypassdioden zur Versorgung der Elektronik im Beschattungsfall vorgesehen werden. Allerdings ist der Spannungsabfall im allgemeinen zu gering, um die erforderliche Spannung einschließlich der benötigten Spannungsdifferenzen zum Schalten von vorzugsweise eingesetzten Leistungs-MOS-FETs zur Verfügung zu stellen. Folglich ist bei dieser Art der Versorgung noch ein DC/DC-Booster zu integrieren, welcher den Schaltungsaufwand und somit die Kosten erhöht.

Eine derartige Photovoltaikanlage ist in der deutschen Patentschrift DE 10 2005 036 153 B4 beschrieben. Das Dokument offenbart eine Schutzschalteinrichtung für ein Solarmodul, bei der der Spannungsabfall über einen Bypasspfad genutzt wird, um mittels einer DC/DC-Boosterschaltung die interne Versorgungsspannung zu generieren. Die hierzu erforderliche Schaltungsanordnung ist relativ aufwendig. Nachteilig ist auch, dass es bei dieser Schutzschaltung nicht möglich ist, das gesamte Photovoltaikmodul an den Außenklemmen durch Kurzschließen spannungsfrei zu schalten, da hierdurch die interne Spannungsversorgung wegfallen würde.

Es stellte sich die Aufgabe, eine gattungsgemäße Photovoltaikanlage zu schaffen, welche einen besonders einfachen und kostengünstigen Aufbau aufweist und die vorgenannten Nachteile vermeidet. Des weiteren stellte sich die Aufgabe ein insbesondere hierzu verwendbares, besonders einfaches und kostengünstiges Photovoltaikmodul zu schaffen.

Diese Aufgaben werden erfindungsgemäß durch die in den Ansprüchen 1 und 11 genannten Merkmale gelöst.

Die die Schalter steuernde Elektronik kann so durch ein jeweils zugeordnetes Photovoltaikmodul mit einer Spannung versorgt werden um ein Freischalten im Gefahrenfall und ein Wiedereinschalten nach dem Gefahrenfall auszuführen oder zu ermöglichen. Dabei bleibt die Spannungsversorgung der Elektronik auch im freigeschalteten Zustand erhalten.

Die Elektronik kann die steuerbaren Schalter vorteilhafterweise derart ansteuern, dass sich das jeweilige Photovoltaikmodul immer im sicheren Zustand befindet. Im Defaultzustand sind die Panelstrings des Photovoltaikmoduls kurzgeschlossen, so dass selbst bei einer Fehlfunktion der Elektronik keine Gefährdung von dem Photovoltaikmodul ausgehen kann.

Besonders vorteilhaft ist, das zur Versorgung der Elektronik weder ein Boosterbetrieb noch ein Umladungstakten erforderlich ist, wodurch die Schaltung besonders einfach und kostengünstig ausführbar ist.

Im folgenden soll die Erfindung anhand der Zeichnung schematisch dargestellt und näher erläutert werden. Es zeigen
- Figur 1: Schaltungsdetails eines Photovoltaikmoduls,
- Figur 2: ein Blockschaltbild einer Photovoltaikanlage.

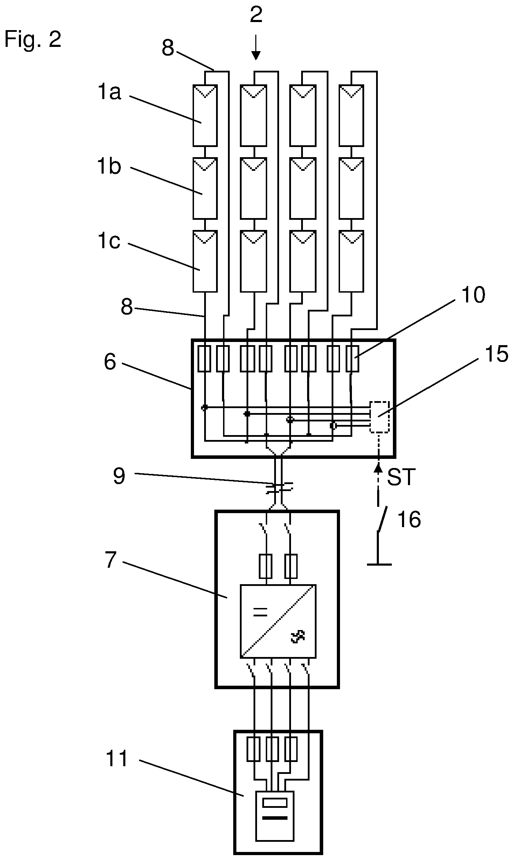

Figur 2 zeigt ein Blockschaltbild, welches den Aufbau und die Funktionsweise einer Photovoltaikanlage verdeutlichen soll. Die Photovoltaikanlage weist mehrere Modulstränge 2 auf, die jeweils aus mehreren, hier beispielhaft drei, in Reihe geschalteten Photovoltaikmodulen 1a, 1b, 1c bestehen, welche über Modulstrangleitungen 8 miteinander in Reihe geschaltet sind.

Die Modulstrangleitungen 8 sind in einer Anschlussdose 6 zusammengeführt und mit einer Hauptanschlussleitung 9 verbunden, welche zum Eingangsanschluss eines Zentralwechselrichters 7 geführt ist. Die Anschlussdose 6 ist hier vom Zentralwechselrichter 7 räumlich getrennt angeordnet und ist vorzugsweise in einer möglichst günstigen räumlichen Lage zur Gesamtheit der Modulstränge 2 platziert. Durch diesen Aufbau kann der Verkabelungsaufwand und insbesondere die Gesamtlänge aller Modulstrangleitungen 8 relativ gering gehalten werden.

Der Zentralwechselrichter 7 hat die Funktion, die von den Photovoltaikmodulen 1a, 1b, 1c erzeugte Gleichspannung in eine Wechselspannung mit einer vorgegebenen Frequenz zu wandeln. Dem Zentralwechselrichter 7 nachgeschaltet ist ein Wechselspannungsschaltschrank 11, der die erzeugte elektrische Energie in ein Spannungsnetz einkoppelt. Der Zentralwechselrichter 7 und der Wechselspannungsschaltschrank 11 können auch eine Baueinheit miteinander bilden.

Sind, wie in der Figur 2 dargestellt, mehr als zwei Modulstränge 2 parallel geschaltet, so ist es vorteilhaft, Strangsicherungen 10 vorzusehen, um zu verhindern, dass in einem fehlerhaften Modulstrang 2 ein Strom fließen kann, der groß genug ist, um Photovoltaikmodule 1 und Verkabelung zu beschädigen. Die Strangsicherungen 10 schützen auch den nachgeschalteten Zentralwechselrichter 7.

Die Strangsicherungen 10 können allerdings keine Gefahren beseitigen, die durch hohe Spannungen an den Modulsträngen 2 selbst entstehen. Kommt es beispielsweise bei einem Haus mit einer Photovoltaikanlage zu einem Brand, so besteht durch die hohen Spannungen an den Modulsträngen 2 Lebensgefahr für die den Brand angreifenden Feuerwehrleute. Daher muss eine Möglichkeit vorgesehen sein, um die Photovoltaikanlage auf sichere Weise spannungsfrei zu schalten.

Zum Freischalten von Photovoltaikmodulen 1a, 1b, 1c bzw. von Modulsträngen 2 gibt es grundsätzlich zwei bekannte Möglichkeiten und zwar erstens das Kurzschließen und zweitens das Trennen der entsprechenden Modulstrangleitungen 8. Da das Freischalten vor der Anschlussdose 6 erfolgen muss, muss die hierzu vorgesehene Elektronik mit den Photovoltaikmodulen 1a, 1b, 1c bzw. den Modulsträngen 2 zusammenwirken.

Hierbei ist es nicht unproblematisch, eine zuverlässige Spannungsversorgung für die Elektronik vorzusehen. Das Freischalten durch Kurzschließen eines Photovoltaikmoduls 1a, 1b, 1c bzw. eines Teils eines Modulstrangs 2 verursacht einen Spannungseinbruch, der für die Elektronik benötigten Versorgungsspannung. Das Freischalten durch Trennen von Modulstrangleitungen 8 beinhaltet die Gefahr des Auftretens von Lichtbögen, da an den Modulstrangleitungen 8 üblicherweise Gleichspannungen von mehreren hundert Volt anliegen.

Des Weiteren wäre aufgrund des Trennens der Modulstrangleitungen 8 eine zusätzliche Kommunikation mit einer zentralen Sensor- und Kommunikationseinheit, zum Beispiel mittels Funkverbindungen oder über zusätzliche Leitungen erforderlich, um nach einer erfolgten Störungsbeseitigung eine Wiedereinschaltinformation an die Elektronik heranzutragen.

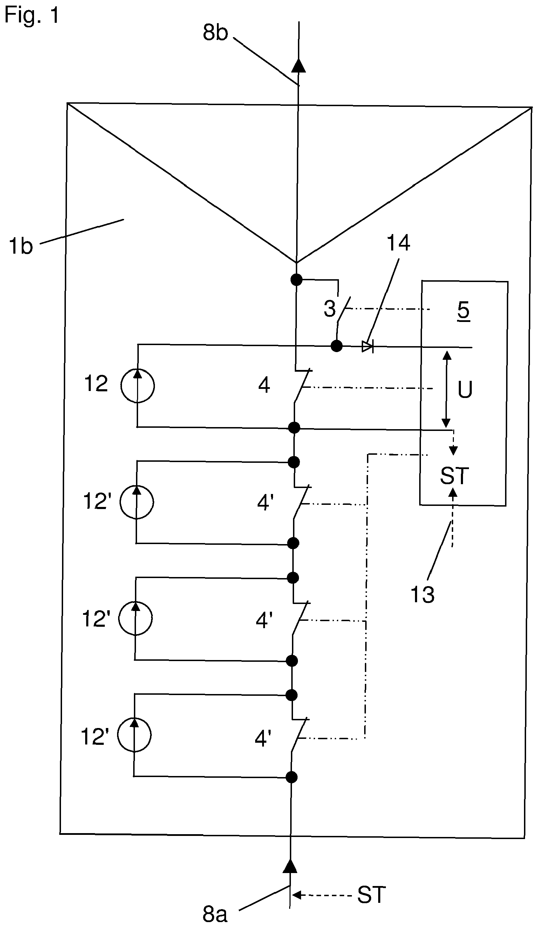

Zur Lösung dieser Probleme weisen bei einer erfindungsgemäßen Photovoltaikanlage die Photovoltaikmodule den in der Figur 1 skizzierten Aufbau auf. Dargestellt ist ein einzelnes Photovoltaikmodul 1b aus dem in der Figur 2 dargestellten Blockschaltbild, wobei vorzugsweise alle in der Figur 2 dargestellten Photovoltaikmodule 1a, 1b, 1c genau gleichartig aufgebaut sind.

Das in der Figur 1 beispielhaft dargestellte Photovoltaikmodul 1b besitzt eine integrierte Elektronik 5 zu Steuerung mehrerer steuerbarer Schalter 3, 4, 4'. Der innere Aufbau der hier nur als Schaltungsblock dargestellten Elektronik 5 kann sich entweder auf eine Anordnung aus wenigen Halbleiterschaltern beschränkt sein oder aber eine "Intelligenz" in Form eines einfachen Mikrocontrollers aufweisen. Auf jeden Falle ist erreichbar, dass die Elektronik 5 nur gering zu den Gesamtkosten des Photovoltaikmoduls 1b beiträgt.

Das Photovoltaikmodul 1b weist wenigstens einen und vorzugsweise mehrere so genannte Panelstrings 12, 12', auf, die jeweils aus einer Reihenschaltung mehrerer, hier nicht dargestellter Solarzellen bestehen. Die Panelstrings 12, 12' sind hier vereinfachend jeweils durch das Schaltungssymbol einer elektrischen Stromquelle dargestellt. Einem ersten Panelstring 12 sind hierbei zwei durch die Elektronik 5 beeinflussbare steuerbare Schalter 3, 4, die in Schaltungsrealisierungen als Halbleiterschalter ausführbar sind, zugeordnet. Mit den weiteren Panelstrings 12' ist jeweils ein steuerbarer Schalter 4' verbunden, der den zugehörige Panelstring 12' überbrückt und im geschlossenen Zustand damit kurzschließt.

Der erste Panelstring 12 ist über eine Verpolschutzdiode 14 mit Eingängen der Elektronik 5 verbunden und stellt dieser eine Versorgungsspannung U zu Verfügung. Der Spannungs- und Strombedarf der Elektronik 5 ist so dimensioniert, dass selbst bei einer Beschattung, also einer nur geringen Beleuchtung des Panelstrings 12, dieser die Elektronik 5 ausreichend mit elektrischer Energie versorgen kann.

Erst bei fast vollständiger Dunkelheit in der Umgebung des Photovoltaikmoduls 1b sinkt die vom Panelstring 12 abgegebene Spannung U soweit ab, dass sie zur Versorgung der Elektronik 5 nicht mehr ausreicht. In diesem Fall ist sicher davon auszugehen, dass das Photovoltaikmodul 1b insgesamt so wenig elektrische Energie erzeugt, dass davon keine Gefährdung ausgehen kann. Darüber hinaus kann die Schaltung vorteilhafterweise so ausgeführt sein, dass ohne eine Ansteuerung durch die Elektronik 5 sich sämtliche steuerbaren Schalter 3, 4, 4' im geschlossenen Zustand befinden, wodurch sämtliche Panelstrings 12, 12' kurzgeschlossen sind, und sich das Photovoltaikmodul 1b in einem sicheren Zustand befindet.

Im störungsfreien Normalbetrieb des Photovoltaikmoduls 1b steuert die Elektronik 5 die steuerbaren Schalter 4 und 4' in den geöffneten Zustand und den steuerbaren Schalter 3 in den geschlossenen Zustand. Hierdurch sind alle Panelstrings 12, 12' in Reihe geschaltet und sowohl mit der ankommenden als auch mit der abgehenden Modulstrangleitung 8a, 8b verbunden, welche das Photovoltaikmodul 1b mit benachbarten Photovoltaikmodule 1a, 1c bzw. mit der Anschlussdose 6 verbinden.

Im Beschattungsfall oder in einem Notfall, der die Abschaltung des Photovoltaikmoduls 1b erfordert, steuert die Elektronik 5 die steuerbaren Schalter 4 und 4' in den geschlossenen Zustand und den steuerbaren Schalter 3 in den geöffneten Zustand. Hierdurch sind die Panelstrings 12' jeweils kurzgeschlossen und damit ungefährlich. Der Panelstring 12 ist als einziger nicht kurzgeschlossen sondern liefert weiterhin die Versorgungsspannung U für die Elektronik 5. Die vom Panelstring 12 erzeugte Spannung U wird aber durch den geöffneten steuerbaren Schalter 3 von den Modulstrangleitungen 8a, 8b genommen. Ersichtlich ist zudem, dass die allesamt geschlossenen steuerbaren Schalter 4 und 4' eine direkte leitende Verbindung zwischen der ankommenden und der abgehenden Modulstrangleitung 8a, 8b herstellen, so dass das Photovoltaikmodul 1b nach außen spannungsfrei ist.

Zur Beeinflussung der Elektronik 5 zwecks Ansteuerung der steuerbaren Schalter 3, 4, 4' sind Steuersignale ST vorgesehen, die auf verschiedene Weise generiert und innerhalb der Photovoltaikanlage weitergegeben werden können.

So können beispielsweise nicht dargestellte Strom-, Spannungs-, oder auch Photosensoren in einem Photovoltaikmodul 1b eine Beschattung des Photovoltaikmoduls 1b erkennen und daraufhin durch ein Steuersignal eine Abschaltung des Photovoltaikmoduls 1b vornehmen. Des Weiteren kann auch ein Übertemperatursensor zur Erzeugung eines Steuersignals ST zur Abschaltung genutzt werden. Da die Elektronik 5, wie erläutert, dabei aktiv bleibt, kann diese nach Beendigung der Beschattung durch ein anderes Steuersignal desselben Sensors auch ein Wiedereinschalten des Photovoltaikmoduls 1b ausführen.

Durch ein, beispielsweise mittels eines Notschalters 16, dargestellt in der Figur 2, manuell erzeugbares Steuersignal ST kann auch eine Abschaltung aller Photovoltaikmodule 1a, 1b, 1c in einem Notfall vorgenommen werden. Das Steuersignal ST kann über Funkverbindungen oder über Steuerleitungen 13 den Photovoltaikmodulen 1a, 1b, 1c zugeführt werden.

Besonders vorteilhaft ist es, Steuersignale ST auf die Modulstrangleitungen 8 zu modulieren. Wie die Figur 2 zeigt kann hierzu eine Modulationsvorrichtung 15 in der Anschlussdose 6 vorgesehen werden, die gleichzeitig sämtliche Modulstrangleitungen 8 ansprechen kann. Die Steuersignale ST erreichen über die Modulstrangleitungen 8 die Photovoltaikmodule 1a, 1b, 1c und werden intern entweder über die geschlossenen steuerbaren Schalter 4, 4' oder über die beleuchteten und damit niederohmigen Panelstrings 12, 12' weitergeleitet und erreichen somit die Elektronik 5 in jedem Photovoltaikmodul 1a, 1b, 1c.

Hierdurch kann jederzeit und besonders in einer Notfallsituation die gesamte Photovoltaikanlage von einer zentralen Stelle aus über einen Notschalter 16 spannungsfrei geschaltet werden. Auf genauso einfache Weise ist nach Beendigung der Notfallsituation auch ein Wiedereinschalten der Photovoltaikanlage möglich.

### Bezugszeichen

- 1a, 1b, 1c: Photovoltaikmodule
- 2: Modulstränge
- 3: erster steuerbarer Schalter
- 4, 4': zweiter steuerbarer Schalter
- 5: Elektronik
- 6: Anschlussdose
- 7: Zentralwechselrichter
- 8, 8a, 8b: Modulstrangleitungen
- 9: Hauptanschlussleitung
- 10: Strangsicherungen
- 11: Wechselspannungsschaltschrank
- 12, 12': Panelstrings
- 13: Steuerleitung
- 14: Verpolschutzdiode
- 15: Modulationsvorrichtung
- 16: Notschalter (manuell betätigbare Vorrichtung)

- ST: Steuersignal(e)
- U: (Versorgungs)Spannung

## Patentansprüche

1. Photovoltaikanlage
mit Photovoltaikmodulen (1a, 1b, 1c), die jeweils mindestens einen aus mehreren Solarzellen bestehenden Panelstring (12, 12') aufweisen,
wobei mehrere Photovoltaikmodule (1a, 1b, 1c) miteinander in Reihe zu Modulsträngen (2) verschaltet sind, und
mit einer Elektronik (5) zum Freischalten von Photovoltaikmodulen (1a, 1b, 1c), deren Versorgungsspannung (U) durch wenigstens eines der Photovoltaikmodule (1b) generiert wird,
**dadurch gekennzeichnet,**
**dass** jedem Panelstring (12, 12') wenigstens ein durch eine Elektronik (5) steuerbarer Schalter (3, 4 bzw. 4') zugeordnet ist, durch den der jeweilige Panelstring (12, 12') elektrisch überbrückbar ist, und
**dass** mindestens ein durch eine Elektronik (5) steuerbarer Schalter (3) vorgesehen ist, der die Reihenschaltung der Photovoltaikmodule (1a, 1b, 1c) innerhalb des Modulstrangs (2) unterbrechen kann.

2. Photovoltaikanlage nach Anspruch 1, **dadurch gekennzeichnet, dass** jedes Photovoltaikmodul (1a, 1b, 1c) eine integrierte Elektronik (5) aufweist.

3. Photovoltaikanlage nach Anspruch 1 oder 2, **dadurch gekennzeichnet, dass** der Elektronik (5) Steuersignale (ST) zuführbar sind, aufgrund derer die Elektronik (5) die Schaltzustände der steuerbaren Schalter (3, 4, 4') beeinflusst.

4. Photovoltaikanlage nach Anspruch 3, **dadurch gekennzeichnet, dass** der Elektronik (5) die Steuersignale (ST) über jeweils eine speziell hierzu vorgesehene Steuerleitung (13) zuführbar sind.

5. Photovoltaikanlage nach Anspruch 3, **dadurch gekennzeichnet, dass** der Elektronik (5) die Steuersignale (ST) über drahtlos übertragbare Signale, insbesondere über Funksignale zuführbar sind.

6. Photovoltaikanlage nach Anspruch 3, **dadurch gekennzeichnet, dass** der Elektronik (5) die Steuersignale (ST) über jeweils eine Modulstrangleitung (8) zuführbar sind, welche mehrere Photovoltaikmodule (1a, 1b,1c) zu einem Modulstrang (2) verbindet.

7. Photovoltaikanlage nach Anspruch 6, **dadurch gekennzeichnet, dass** eine Modulationsvorrichtung (15) vorgesehen ist, die die Steuersignale (ST) auf die Modulstrangleitung (8) aufmoduliert.

8. Photovoltaiksignale nach Anspruch 3, **dadurch gekennzeichnet, dass** Steuersignale (ST) durch eine manuell betätigbare Vorrichtung (16) erzeugbar sind.

9. Photovoltaiksignale nach Anspruch 3, **dadurch gekennzeichnet, dass** Steuersignale (ST) auf der Grundlage von erfassten Sensordaten durch automatische Vorrichtungen erzeugbar sind.

10. Photovoltaiksignale nach Anspruch 3, **dadurch gekennzeichnet, dass** unterschiedliche Steuersignale (ST) ein Freischalten oder ein Wiederzuschalten von Photovoltaikmodulen (1a, 1b, 1c) bewirken.

11. Photovoltaikmodul für eine Photovoltaikanlage mit der Gesamtheit der Merkmale des Anspruchs 1, sowie
mit mindestens einem aus mehreren Solarzellen bestehenden Panelstring (12, 12') und
mit Modulstrangleitungen (8, 8a, 8b) zum Herausführen elektrischer Energie aus dem Photovoltaikmodul (1a, 1b, 1c),
**dadurch gekennzeichnet,**
**dass** wenigstens ein erster Panelstring (12) die Versorgungsspannung (U) für eine in das Photovoltaikmodul (1b) integrierte Elektronik (5) generiert,
**dass** jedem Panelstring (12, 12') wenigstens ein durch die Elektronik (5) steuerbarer Schalter (3, 4 bzw. 4') zugeordnet ist, durch den der jeweilige Panelstring (12, 12') elektrisch überbrückbar ist, und
**dass** mindestens ein durch die Elektronik (5) steuerbarer Schalter (3) vorgesehen ist, der im geschossenen Zustand einen Anschluss des ersten Panelstrings (12) mit einer Modulstrangleitung (8b) verbindet.

## Claims

1. Photovoltaic facility
having photovoltaic modules (1a, 1b, 1c) each of which has at least one string of panels (12, 12') composed of a plurality of solar cells,
wherein a plurality of photovoltaic modules (1a, 1b, 1c) are series-connected to each other to form module strings (2), and
having an electronic assembly (5) for activating photovoltaic modules (1a, 1b, 1c), whose supply voltage (U) is generated by at least one of the photovoltaic modules (1b),
**characterised in that**
allocated to each string of panels (12, 12') is at least one switch (3, 4 or 4') which can be controlled by an electronic assembly (5) and by means of which the relevant string of panels (12, 12') can be electrically bridged, and
that at least one switch (3) is provided that can be controlled by an electronic assembly (5) and which can interrupt the series connection of the photovoltaic modules (1a, 1b, 1c) within the module string (2).

2. Photovoltaic facility according to Claim 1, **characterised in that** each photovoltaic module (1a, 1b, 1c) has an integrated electronic assembly (5).

3. Photovoltaic facility according to Claim 1 or Claim 2, **characterised in that** control signals (ST) can be fed to the electronic assembly (5) as a result of which the electronic assembly (5) influences the switching states of the controllable switches (3, 4, 4').

4. Photovoltaic facility according to Claim 3, **characterised in that** the control signals (ST) can be fed to the electronic assembly (5) by way of a control line (13) provided specifically for this purpose in each case.

5. Photovoltaic facility according to Claim 3, **characterised in that** the control signals (ST) can be fed to the electronic assembly (5) via wirelessly transmissible signals, in particular via radio signals.

6. Photovoltaic facility according to Claim 3, **characterised in that** the control signals (ST) can be fed to the electronic assembly (5) via a module string cable (8) in each case which connects a plurality of photovoltaic modules (1a, 1b, 1c) into a module string (2).

7. Photovoltaic facility according to Claim 6, **characterised in that** a modulation means (15) is provided which modulates the control signals (ST) on the module string cable (8).

8. Photovoltaic signals according to Claim 3, **characterised in that** control signals (ST) can be generated by means of manually operable equipment (16).

9. Photovoltaic signals according to Claim 3, **characterised in that** control signals (ST) can be generated by automatic equipment on the basis of captured sensor data.

10. Photovoltaic signals according to Claim 3, **characterised in that** different control signals (ST) cause photovoltaic modules (1a, 1b, 1c) to be activated or switched on again.

11. Photovoltaic module for a photovoltaic facility having the entirety of the characteristics set out in Claim 1, and
having at least one string of panels (12, 12') consisting of a plurality of solar cells, and
having module string cables (8, 8a, 8b) for the purpose of feeding electrical power out of the photovoltaic module (1a, 1b, 1c),
**characterised in that**
at least one first string of panels (12) generates the supply voltage (U) for an electronic assembly (5) integrated in the photovoltaic module (1b),
that allocated to each string of panels (12, 12') is at least one switch (3, 4 or 4') which can be controlled by an electronic assembly (5) and by means of which the relevant string of panels (12, 12') can be electrically bridged, and
that at least one switch (3) is provided which can be controlled by an electronic assembly (5) and which, in its closed state, connects a terminal lead from the first string of panels (12) to a module string cable (8b).

## Revendications

1. Installation photovoltaïque
avec des modules photovoltaïques (1a, 1b, 1c), qui présentent chacun au moins une chaîne de panneaux (12, 12') qui consiste en plusieurs cellules solaires,
sachant que plusieurs modules photovoltaïques (1a, 1b, 1c) sont connectés ensemble en série pour former des branches de modules (2), et
avec un système électronique (5), destiné à la libération de modules photovoltaïques (1a, 1b, 1c), dont la tension d'alimentation (U) est générée par au moins l'un des modules photovoltaïques (1b),
**caractérisée en ce**
**qu'**à chaque chaîne de panneaux (12, 12') est associé au moins un commutateur (3, 4, respectivement 4') pouvant être commandé par un système électronique (5), au moyen duquel la chaîne de panneaux (12, 12') concernée peut être pontée électriquement, et
**qu'**est prévu au moins un commutateur (3), qui, pouvant être commandé par le système électronique (5), peut interrompre la connexion en série des modules photovoltaïques (1a, 1b, 1c), à l'intérieur de la branche de modules (2).

2. Installation photovoltaïque selon la revendication 1, **caractérisée en ce que** chaque module photovoltaïque (1a, 1b, 1c), présente un système électronique intégré (5).

3. Installation photovoltaïque selon revendication 1 ou 2, **caractérisée en ce que** des signaux de commande (ST) peuvent être conduits au système 'électronique (5), signaux en fonction desquels le système électronique (5) influence les états de connexion des commutateurs commandés (3, 4, 4').

4. Installation photovoltaïque selon la revendication 3, **caractérisée en ce que** les signaux de commande (ST) peuvent être conduits au système électronique (5), chacun par l'intermédiaire d'une conduite électrique (13) spécialement prévue dans ce but.

5. Installation photovoltaïque selon la revendication 3, **caractérisée en ce que** les signaux de commande (ST) peuvent être conduits au système électronique (5) par l'intermédiaire de signaux transmissibles sans fil, en particulier par l'intermédiaire de signaux radio.

6. Installation photovoltaïque selon la revendication 3, **caractérisée en ce que** les signaux de commande (ST) peuvent être conduits au système électronique (5), chacun par l'intermédiaire d'une conduite de branche de modules (8), qui relie plusieurs modules photovoltaïques (1a, 1b, 1c) en branche de modules (2).

7. Installation photovoltaïque selon la revendication 6, **caractérisée en ce qu'**est prévu un dispositif de modulation (15), qui module les signaux de commande (ST) sur la conduite de branche de modules (8).

8. Signaux photovoltaïques selon la revendication 3, **caractérisés en ce que** des signaux de commande (ST) peuvent être générés par un dispositif (16) pouvant être actionné manuellement.

9. Signaux photovoltaïques selon la revendication 3, **caractérisés en ce que** des signaux de commande (ST) peuvent être générés sur la base de données sensorielle par des dispositifs automatiques.

10. Signaux photovoltaïques selon la revendication 3, **caractérisés en ce que** des signaux de commande (ST) différents provoquent une libération et / ou une reconnexion de modules photovoltaïques (1a, 1b, 1c).

11. Module photovoltaïque pour une installation photovoltaïque présentant la totalité des caractéristiques de la revendication 1, ainsi
qu'avec au moins une chaîne de panneaux (12, 12') consistant en plusieurs cellules solaires, et
avec des conduites de branches de modules (8, 8a, 8b) pour conduire l'énergie
électrique hors du module photovoltaïque (1a, 1b, 1c),
**caractérisé en ce**
**qu'**au moins une première chaîne de panneaux (12) génère la tension d'alimentation (U) pour un système électronique (5) intégré dans le module photovoltaïque (1b),
qu"à chaque chaîne de panneaux (12, 12') est associé au moins un commutateur (3, 4, respectivement 4') pouvant être commandé par le système électronique (5), au moyen duquel la chaîne de panneaux (12, 12') concernée peut être pontée électriquement, et
**qu'**est prévu au moins un commutateur (3), qui, pouvant être commandé par le système électronique (5), relie, à l'état fermé, un raccord de la première chaîne de panneaux (12) à la conduite de branche de modules (8).
